# EUROPEAN PATENT APPLICATION

(11) **EP 4 738 319 A1**
(43) Date of publication of application: **06.05.2026**
(21) Application number: 25150180.5
(22) Date of filing: 03.01.2025
(51) Int. Cl.: G09F 9/302, G09F 9/33

(54) **LATCH ASSEMBLY, LED DISPLAY SCREEN CABINET, AND LED DISPLAY SCREEN**

(30) Priority: 29.10.2024 CN 202422617432 U
(71) Applicant: Shenzhen Infiled Electronics Co., Ltd, Tangtou, ShiyanTown, Baoan District Shenzhen Guangdong 518100 (CN)
(72) Inventor: GUO, Yang, Shenzhen (CN); LUO, Xin, Shenzhen (CN); TU, Shengzhi, Shenzhen (CN)
(74) Representative: Isern Patentes y Marcas S.L.

(57) **Abstract**

The present invention relates to the technical field of LED display devices, in particular to a latch assembly, an LED display screen cabinet, and an LED display screen. The latch assembly is configured to assemble two connected pieces into a single unit and includes a connecting base, a locking housing, a locking rod, and a handle. A stroke groove is formed on a side wall of the locking housing, and a first limiting groove and a second limiting groove, which are in communication with the stroke groove, are formed on a top wall of the locking housing; when the handle moves from the first limiting groove through the stroke groove to the second limiting groove, the locking rod is in a locked state; when the handle moves from the second limiting groove through the stroke groove to the first limiting groove, the locking rod is in an unlocked state. According to the present application, the first limiting groove and the second limiting groove are formed at the top of the locking housing, ensuring that the handle remains vertically arranged in the unlocked state or the locked state. This prevents the handle from exceeding the edge of the connected pieces, improving safety in the transportation and use processes, and meanwhile ensuring that there is no interference with adjacent cabinets or other objects.

## Description

The present disclosure is based on the Chinese patent application with application No. 202422617432.9, filed on October 29, 2024, and claims priority from this Chinese patent application. The entire content of this Chinese patent application is hereby incorporated by reference into the present application.

### Technical field

The present invention relates to the technical field of LED display devices, in particular to a latch assembly, an LED display screen cabinet, and an LED display screen.

### Background of invention

An LED display screen is often used for displaying various information such as texts, images, and videos. The existing LED display screen is generally formed by assembling modular LED display cabinets. In the assembling process of the LED display screen cabinets, a connecting lock is usually used, through which two parts of the cabinets are assembled into a single unit. However, the operating handle on the existing connecting lock is too long and the projection of the operating handle onto the display screen frame extends the edge of the display screen frame. This may lead to damage to adjacent cabinets in the transportation and use processes. If the operating handle is too short, it is likely to forget to fasten the lock during the installation of the cabinets, posing a significant safety hazard.

### Summary of invention

In order to solve the problems in the background section, the present invention provides a latch assembly, an LED display screen cabinet, and an LED display screen. Two connected pieces are locked and unlocked through a latch connection method, and when a locking rod is in a locked state or an unlocked state, a handle is vertically arranged. This prevents the handle from exceeding the edge of the connected pieces, improving the safety in the transportation and use processes.

In a first aspect of the present invention, a latch assembly is provided. The latch assembly is configured to assemble two connected pieces into a single unit, and the latch assembly includes a connecting base, a locking housing fixed on the connecting base, a locking rod movably arranged in the locking housing, and a handle vertically fixed on the locking rod, wherein:
a stroke groove extending along a length direction is formed on a side wall of the locking housing, and a first limiting groove and a second limiting groove, which are in communication with the stroke groove and located on one side of the stroke groove, are formed on a top wall of the locking housing; and
when the handle moves from the first limiting groove through the stroke groove to the second limiting groove, the locking rod is in a locked state; when the handle moves from the second limiting groove through the stroke groove to the first limiting groove, the locking rod is in an unlocked state; when the locking rod is in the locked state or the unlocked state, the handle is vertically arranged.

Further, the locking rod is provided with a resilient unit for providing rotational force to the locking rod; when in a locked position or an unlocked position, the handle automatically returns to the second limiting groove or the first limiting groove under an action of the resilient unit.

Further, the resilient unit is a return spring fitted onto the locking rod.

Further, a support piece is provided at one end, in the locking housing, of the locking rod, and one end, near the support piece, of the locking rod forms a limiting step; one end of the return spring abuts against the support piece, and the other end of the return spring abuts against the limiting step.

Further, the support piece includes a support portion and a sliding portion, wherein the support portion is connected to one end of the locking rod through a first fixing piece, and the locking rod is rotatably arranged on the support portion; a sliding groove, adapted to the sliding portion, is formed on the connecting base, and when the locking rod moves, the sliding portion is arranged to move along with the locking rod within the sliding groove.

Further, a guide groove extending along a length direction is formed in the locking housing, and the locking rod is movably arranged in the guide groove; one end of the guide groove is in communication with the outside through the stroke groove, the first limiting groove, and the second limiting groove.

Further, the connecting base takes an L-shaped structure, a vertical end of the connecting base is fixedly connected to one of the connected pieces, and the locking rod is movably mounted at a horizontal end of the connecting base; the locking rod is detachably connected to the other connected piece.

Further, the locking housing is fixedly connected to the connecting base through a second fixing piece.

In a second aspect of the present invention, an LED display screen cabinet is provided. The LED display screen cabinet includes a first frame and a second frame and further includes any latch assembly described above. The first frame is fixed on one end of the connecting base, and a latch hole is formed on the second frame; a free end of the locking rod aligns with the latch hole, and when the handle moves from the first limiting groove through the stroke groove to the second limiting groove, the locking rod is inserted into the latch hole.

In a third aspect of the present invention, an LED display screen is provided. The LED display screen includes any latch assembly described above.

Compared with the prior art, the present invention has the following beneficial effects:
(1) The latch assembly of the present invention includes a connecting base, a locking housing, a locking rod, and a handle. The handle is vertically fixed on the locking rod and drives the locking rod to rotate and move; when the handle moves from the first limiting groove through the stroke groove to the second limiting groove, the locking rod is in a locked state; when the handle moves from the second limiting groove through the stroke groove to the first limiting groove, the locking rod is in an unlocked state. The connection of two connected pieces is achieved through the locking rod, which features a simple structure and convenient operation. Moreover, when the locking rod is in the locked state or unlocked state, the handle is vertically arranged, preventing the handle from exceeding the edge of the connected pieces and improving safety in the transportation and use processes.
(2) A resilient unit is provided on the locking rod of the latch assembly of the present invention, such that the locking rod is in a locked position or an unlocked position, and the handle automatically returns to the second limiting groove or the first limiting groove under the action of the resilient unit. This ensures that in the locked or unlocked state, the handle automatically remains vertical, ensuring the overall structural aesthetic of the cabinet and reducing the likelihood of interference with other structures.

### Brief description of drawings

In order to more clearly illustrate the technical solutions in the embodiments of the present invention or in the prior art, the drawings required to be used in the description of the embodiments or the prior art are briefly introduced below. It is obvious that the drawings in the description below are some embodiments recorded in the present invention, and those of ordinary skill in the art can obtain other drawings according to the drawings provided herein without creative efforts.
FIG. 1 is an overall structural diagram of a latch assembly in an unlocked state according to an embodiment of the present application;
FIG. 2 is a state diagram of a locking rod of a latch assembly moving to a locked state according to an embodiment of the present application;
FIG. 3 is a structural diagram of a latch assembly without a locking housing according to an embodiment of the present application;
FIG. 4 is an exploded diagram of a latch assembly according to an embodiment of the present application;
FIG. 5 is an internal structural diagram of a locking housing according to an embodiment of the present application;
FIG. 6 is a structural diagram of a locking housing according to an embodiment of the present application; and
FIG. 7 is a schematic structural diagram of a latch assembly connecting two connected pieces according to an embodiment of the present application.

In the figures: 1-connecting base, 11-sliding groove, 12-first connecting plate, 13-second connecting plate, 2-locking housing, 21-stroke groove, 22-first limiting groove, 23-second limiting groove, 24-guide groove, 3-locking rod, 31-limiting step, 32-insertion end, 4-handle, 5-resilient unit, 6-support piece, 61-support portion, 62-sliding portion, 63-first fixing piece, 7-second fixing piece, and 8-connected piece.

### Detailed desceiption of preferred embodiment

The technical solutions in the embodiments of the present invention will be clearly and completely described below with reference to the drawings in the present invention, and it is obvious that the described embodiments are only a part of the embodiments of the present invention but not all of them. Based on the embodiments of the present invention, all other embodiments obtained by those of ordinary skill in the art without creative efforts shall fall within the protection scope of the present invention.

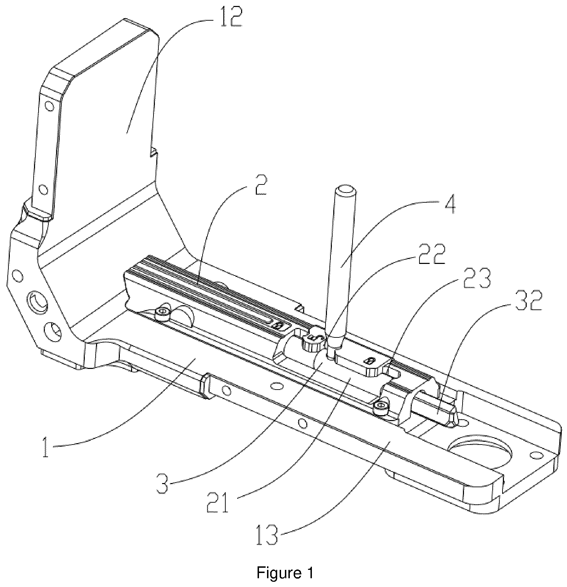

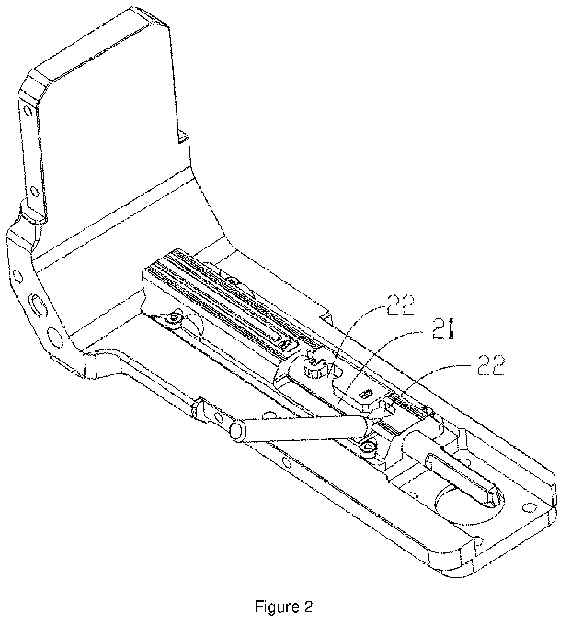

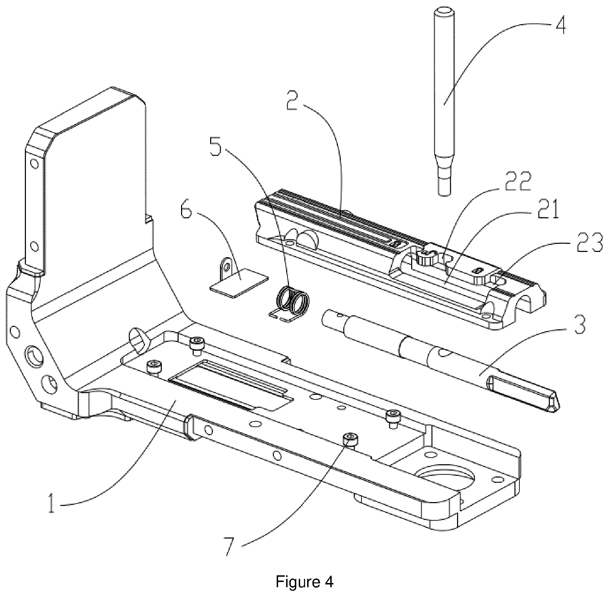

The present invention is discussed in detail below with reference to FIGS. 1-7 and specific embodiments.

As shown in FIGS. 1-7, the present invention provides a latch assembly for assembling two connected pieces 8 into a single unit, and the connected pieces 8 may be two separate cabinet frames but are not limited thereto. The latch assembly of the present application includes a connecting base 1, a locking housing 2 fixed on the connecting base 1, a locking rod 3 movably arranged in the locking housing 2, and a handle 4 vertically fixed on the locking rod 3. A stroke groove 21 extending along a length direction is formed on the side wall of the locking housing 2, and a first limiting groove 22 and a second limiting groove 23, which are in communication with the stroke groove 21 and located on one side of the stroke groove 21, are formed on the top wall of the locking housing 2. When the handle 4 moves from the first limiting groove 22 through the stroke groove 21 to the second limiting groove 23, the locking rod 3 is in a locked state; when the handle 4 moves from the second limiting groove 23 through the stroke groove 21 to the first limiting groove 22, the locking rod 3 is in an unlocked state. When the locking rod 3 is in the locked state or the unlocked state, the handle 4 is vertically arranged. It can be known that the handle 4 is fixed on the locking rod 3 and the movement of the handle 4 drives the locking rod 3 to move together. One end, away from the locking housing 2, of the locking rod 3 forms an insertion end 32. When the handle 4 moves into the second limiting groove 23, the insertion end 32 extends out and inserts into an insertion hole of the connected pieces to achieve connection; when the handle 4 moves into the first limiting groove 22, the insertion end 32 retracts backward and exits the connected pieces, such that the connected pieces can be separated from the latch assembly.

According to the present application, the first limiting groove 22 and the second limiting groove 23 are formed at the top of the locking housing 2, ensuring that the handle 4 remains vertically arranged in the unlocked state or the locked state. This prevents the handle 4 from exceeding the edge of the connected pieces, improving safety in the transportation and use processes, and meanwhile ensuring that there is no interference with adjacent cabinets or other objects.

It should be noted that the present application does not limit the method in which the handle 4 enters the first limiting groove 22 or the second limiting groove 23 from the stroke groove 21. For example, the handle 4 may be manually pushed upward to snap the handle 4 into the first limiting groove 22 or the second limiting groove 23, and the handle 4 cannot easily exit the first limiting groove 22 or the second limiting groove 23. In the above method, the groove shapes of the first limiting groove 22 and the second limiting groove 23 need to be specifically designed and the side openings preferably have a certain elastic deformation to enable the lower end of the handle 4 to snap therein. However, this is not the only method.

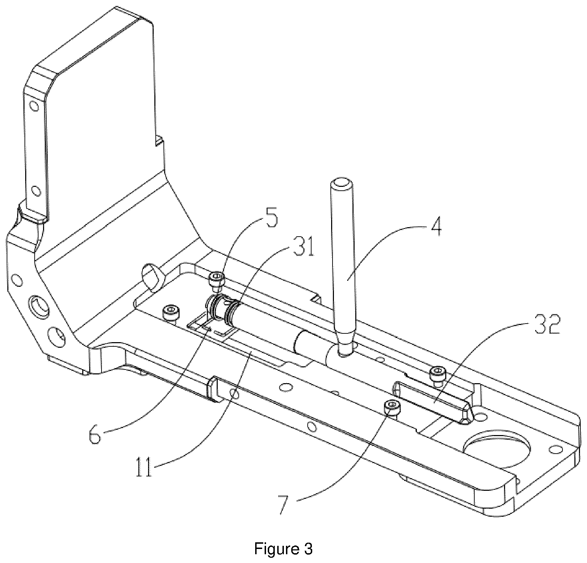

In some embodiments, referring to FIGS. 3-5, the locking rod 3 is provided with a resilient unit 5 for providing rotational force to the locking rod 3; when in a locked position or an unlocked position, the handle 4 automatically returns to the second limiting groove 23 or the first limiting groove 22 under the action of the resilient unit 5. In other words, the resilient unit 5 has the function of rotating the handle 4 to be positioned in a vertical state. When the handle 4 moves to the opening of the first limiting groove 22 or the second limiting groove 23 in the stroke groove 21, the resilient unit 5 automatically causes the handle 4 to enter the first limiting groove 22 or the second limiting groove 23 and be in a vertical state. This ensures that in the locked or unlocked state, the handle 4 automatically remains vertical, which can not only avoid interference with other adjacent objects but also ensure the overall structural aesthetic of the cabinet. Due to the arrangement of the resilient unit 5, the present application prevents the situation where the locking rod 3 slides into place and inserts into the connected pieces but is forgotten to be locked, leading to potential safety hazards. In the above embodiment, the openings of the first limiting groove 22 and the second limiting groove 23 should be appropriately large, such that the handle 4 can easily enter under the action of the resilient unit 5.

In a specific embodiment, the resilient unit 5 is a return spring fitted onto the locking rod 3, and the return spring drives the locking rod 3 to rotate, so as to further drive the handle 4 to rotate.

Specifically, a support piece 6 is provided at one end, in the locking housing 2, of the locking rod 3, and one end, near the support piece 6, of the locking rod 3 forms a limiting step 31. One end of the return spring abuts against the support piece 6, and the other end of the return spring abuts against the limiting step 31. Moreover, the return spring is fixed on the locking rod 3 through a fixing piece. Preferably, the return spring is a torsion spring. If the locking rod 3 is rotated by a certain angle under an external force and the external force is then removed, the locking rod 3 will return to an initial position under the action of the return spring. The initial position in the present application is the position where the handle 4 is in a vertical state.

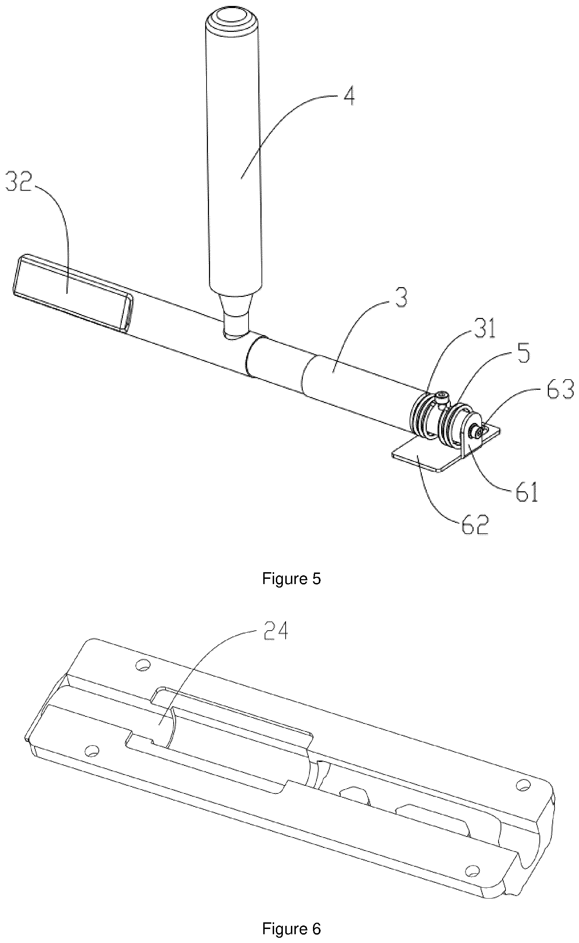

Specifically, referring to FIG. 5, the support piece 6 includes a support portion 61 and a sliding portion 62. The support portion 61 is connected to one end of the locking rod 3 through a first fixing piece 63, and the locking rod 3 is rotatably arranged on the support portion 61; the support portion 61 provides limitation for the return spring. A sliding groove 11 adapted to the sliding portion 62 is formed on the connecting base 1. When the locking rod 3 moves, the sliding portion 62 is arranged to move along with the locking rod 3 within the sliding groove 11, and the sliding portion 62 provides guidance for the movement of the locking rod 3.

In some embodiments, referring to FIGS. 5 and 6, a guide groove 24 extending along a length direction is formed in the locking housing 2. The locking rod 3 is movably arranged in the guide groove 24. One end of the guide groove 24 is in communication with the outside through the stroke groove 21, the first limiting groove 22, and the second limiting groove 23. That is, the other end, away from the insertion end 32, of the locking rod 3 is movably arranged in the guide groove 24 and only moves within the range of the sliding groove 11. The arrangement of the guide groove 24 restricts the degree of freedom of the locking rod 3, such that the locking rod 3 can only move along the length direction of the locking housing 2 and the insertion end 32 can be ensured to be accurately inserted into the connected pieces.

Specifically, referring to FIGS. 1-4, the connecting base 1 takes an L-shaped structure. The vertical end of the connecting base 1 is fixedly connected to one of the connected pieces, and the locking rod is movably mounted at the horizontal end of the connecting base 1; the locking rod is detachably connected to the other connected piece. Further, the connecting base 1 includes a first connecting plate 12 arranged vertically and a second connecting plate 13 arranged horizontally. A threaded hole is formed on the first connecting plate 12, and a through hole is formed on the connected piece connected to the first connecting plate 12. A bolt or a screw passes through the through hole and is screwed into the threaded hole, so as to achieve the connection between the first connecting plate 12 and one of the connected pieces 8. The locking housing 2 and the locking rod 3 are mounted on the second connecting plate 13 for connection with the other connected piece 8. Of course, the L-shaped structure of the connecting base 1 is only a preferred embodiment, and in other embodiments, the specific structure of the connecting base may be designed according to the positional relationship of the two connected pieces. All connecting bases, as long as they can enable two connected pieces in different positions to be connected into a single unit, fall within the protection scope of the present application.

Specifically, the locking housing 2 is fixedly connected to the connecting base 1 through a second fixing piece 7.

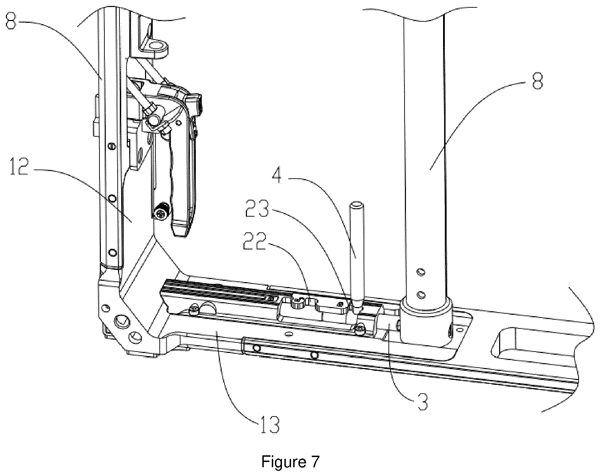

Referring to FIG. 7, the present invention further provides an LED display screen cabinet, which includes a first frame and a second frame. The first frame and the second frame are equivalent to two connected pieces 8. The LED display screen cabinet further includes any latch assembly described above. The first frame is fixed at one end of the connecting base 1, and a latch hole is formed on the second frame. The free end of the locking rod 3 aligns with the latch hole, and when the handle 4 moves from the first limiting groove 22 through the stroke groove 21 to the second limiting groove 23, the locking rod 3 is inserted into the latch hole.

The present invention further provides an LED display screen, which includes any latch assembly described above.

Since the LED display screen cabinet and the LED display screen of the embodiment adopt all technical solutions of all embodiments of the above latch assembly, they possess at least all the beneficial effects brought by the technical solutions of the embodiments of the above latch assembly, which will not be described herein again.

The present invention is further described above in conjunction with specific embodiments, but it should be understood that the specific description herein should not be construed as limiting the spirit and scope of the present invention and that various modifications to the above embodiments made by those of ordinary skill in the art upon reading the specification fall within the protection scope of the present invention

## Claims

1. A latch assembly, configured to assemble two connected pieces into a single unit, the latch assembly comprising a connecting base, a locking housing fixed on the connecting base, a locking rod movably arranged in the locking housing, and a handle vertically fixed on the locking rod, wherein:
a stroke groove extending along a length direction is formed on a side wall of the locking housing, and a first limiting groove and a second limiting groove, which are in communication with the stroke groove and located on one side of the stroke groove, are formed on a top wall of the locking housing; and
when the handle moves from the first limiting groove through the stroke groove to the second limiting groove, the locking rod is in a locked state; when the handle moves from the second limiting groove through the stroke groove to the first limiting groove, the locking rod is in an unlocked state; when the locking rod is in the locked state or the unlocked state, the handle is vertically arranged.

2. The latch assembly according to claim 1, wherein the locking rod is provided with a resilient unit for providing rotational force to the locking rod; when in a locked position or an unlocked position, the handle automatically returns to the second limiting groove or the first limiting groove under an action of the resilient unit.

3. The latch assembly according to claim 2, wherein the resilient unit is a return spring fitted onto the locking rod.

4. The latch assembly according to claim 3, wherein a support piece is provided at one end, in the locking housing, of the locking rod, and one end, near the support piece, of the locking rod forms a limiting step; one end of the return spring abuts against the support piece, and the other end of the return spring abuts against the limiting step.

5. The latch assembly according to claim 4, wherein the support piece comprises a support portion and a sliding portion, wherein the support portion is connected to one end of the locking rod through a first fixing piece, and the locking rod is rotatably arranged on the support portion; a sliding groove, adapted to the sliding portion, is formed on the connecting base, and when the locking rod moves, the sliding portion is arranged to move along with the locking rod within the sliding groove.

6. The latch assembly according to claim 1, wherein a guide groove extending along a length direction is formed in the locking housing, and the locking rod is movably arranged in the guide groove; one end of the guide groove is in communication with the outside through the stroke groove, the first limiting groove, and the second limiting groove.

7. The latch assembly according to claim 1, wherein the connecting base takes an L-shaped structure, a vertical end of the connecting base is fixedly connected to one of the connected pieces, and the locking rod is movably mounted at a horizontal end of the connecting base; the locking rod is detachably connected to the other connected piece.

8. The latch assembly according to claim 1, wherein the locking housing is fixedly connected to the connecting base through a second fixing piece.

9. An LED display screen cabinet, comprising a first frame and a second frame and further comprising the latch assembly according to any one of claims 1 to 8, wherein the first frame is fixed on one end of the connecting base, and a latch hole is formed on the second frame; a free end of the locking rod aligns with the latch hole, and when the handle moves from the first limiting groove through the stroke groove to the second limiting groove, the locking rod is inserted into the latch hole.

10. An LED display screen, comprising the latch assembly according to any one of claims 1 to 8.

## Amended claims

### Amended claims in accordance with Rule 137(2) EPC.

1. A latch assembly, configured to assemble two connected pieces (8) into a single unit, the latch assembly comprising a connecting base (1), a locking housing (2) fixed on the connecting base (1), a locking rod (3) movably arranged in the locking housing (2), and a handle (4) vertically fixed on the locking rod (3), wherein:
a stroke groove (21) extending along a length direction is formed on a side wall of the locking housing (2), and a first limiting groove (22) and a second limiting groove (23), which are in communication with the stroke groove (21) and located on one side of the stroke groove (21), are formed on a top wall of the locking housing (2); and
when the handle (4) moves from the first limiting groove (22) through the stroke groove (21) to the second limiting groove (23), the locking rod (3) is in a locked state; when the handle (4) moves from the second limiting groove (23) through the stroke groove (21) to the first limiting groove (22), the locking rod (3) is in an unlocked state; when the locking rod (3) is in the locked state or the unlocked state, the handle (4) is vertically arranged;
**characterized in that**,
wherein the locking rod (3) is provided with a resilient unit (5) for providing rotational force to the locking rod (3); when in a locked position or an unlocked position, the handle (4) automatically returns to the second limiting groove (23) or the first limiting groove (22) under an action of the resilient unit (5).

2. The latch assembly according to claim 1, wherein the resilient unit (5) is a return spring fitted onto the locking rod (3).

3. The latch assembly according to claim 2, wherein a support piece (6) is provided at one end, in the locking housing (2), of the locking rod (3), and one end, near the support piece (6), of the locking rod (3) forms a limiting step (31); one end of the return spring abuts against the support piece (6), and the other end of the return spring abuts against the limiting step (31).

4. The latch assembly according to claim 3, wherein the support piece (6) comprises a support portion (61) and a sliding portion (62), wherein the support portion (61) is connected to one end of the locking rod (3) through a first fixing piece (63), and the locking rod (3) is rotatably arranged on the support portion (61); a sliding groove (11), adapted to the sliding portion (62), is formed on the connecting base (1), and when the locking rod (3) moves, the sliding portion (62) is arranged to move along with the locking rod (3) within the sliding groove (11).

5. The latch assembly according to claim 1, wherein a guide groove (24) extending along a length direction is formed in the locking housing (2), and the locking rod (3) is movably arranged in the guide groove (24); one end of the guide groove (24) is in communication with the outside through the stroke groove (21), the first limiting groove (22), and the second limiting groove (23).

6. The latch assembly according to claim 1, wherein the connecting base (1) takes an L-shaped structure, a vertical end of the connecting base (1) is fixedly connected to one of the connected pieces (8), and the locking rod (3) is movably mounted at a horizontal end of the connecting base (1); the locking rod (3) is detachably connected to the other connected piece (8).

7. The latch assembly according to claim 1, wherein the locking housing (2) is fixedly connected to the connecting base (1) through a second fixing piece (7).

8. An LED display screen cabinet, comprising a first frame and a second frame and further comprising the latch assembly according to any one of claims 1 to 7, wherein the first frame is fixed on one end of the connecting base (1), and a latch hole is formed on the second frame; a free end of the locking rod (3) aligns with the latch hole, and when the handle (4) moves from the first limiting groove (22) through the stroke groove (21) to the second limiting groove (23), the locking rod (3) is inserted into the latch hole.

9. An LED display screen, comprising the latch assembly according to any one of claims 1 to 7.
